Europäisches Patentamt

European Patent Office

Office européen des brevets

(19)

(11) Publication number: **0 266 844**
**A2**

(12) **EUROPEAN PATENT APPLICATION**

(21) Application number: **87202122.5**

(22) Date of filing: **03.11.87**

(51) Int. Cl.⁴: **B23K 1/00**

(30) Priority: **04.11.86 ES 8602897**

(43) Date of publication of application:
**11.05.88 Bulletin 88/19**

(84) Designated Contracting States:
**AT BE CH DE ES FR GB GR IT LI LU NL**

(71) Applicant: **Bienvenido DEL PINO MILLAN**
**Sector Foresta 24 Tres Cantos**
**Colmenar Viejo Madrid(ES)**

(72) Inventor: **Bienvenido DEL PINO MILLAN**
**Sector Foresta 24 Tres Cantos**
**Colmenar Viejo Madrid(ES)**

(74) Representative: **Kooy, Leendert Willem et al**
**OCTROOIBUREAU VRIESENDORP & GAADE**
**P.O. Box 266**
**NL-2501 AW The Hague(NL)**

(54) **Automatic portable unsolderer.**

(57) Automatic portable unsolderer consisting of a solenoid supplied by alternating current, a cylinder whose piston has a rod constituting the core of said solenoid, including too a reservoir and a heating member, all of them axially engaged as above-mentioned. Through the heating member end, the material that has to be unsoldered is melted and through operation of the solenoid, the piston draws back and suctions said material, which is collected, in a solid condition, in the reservoir which includes a retaining member, easily removable, and a threaded plug. On the outlet of the reservoir a one-way valve is disposed so that the air compressed by the piston, through a return spring that encircles the rod doesn't flow through the suction conduct avoiding in such manner that the air can drag soldering material particles. The ejected air is by-passed through a side hole provided with a one-way valve that is reversely oriente.

FIG.1

This invention refers to an automatic portable unsolderer according to the type used in Electronics.

Conventionally, in the industry and, in particular in Electronics, the unsolderers which are used belong to two important groups : stationary unsolderers or unsoldering units, and manual unsolderers.

The stationary unsolderers consist of a system that continuously pumps the welding material, that is, by pumping air through a conduct on whose end is an electric resistance that holds at a given temperature said conduct, which ends at the unsoldering tip.

These unsolderers or unsoldering units have some disadvantages, among which is the limitation caused by their immovability, not enabling the application by users that require a displacement. Besides, there is another disadvantage, as important as the first, that is, the cost of these big and sophisticated unsolderers, being their use reduced to the scope of the big Companies which are, finally, those that can get a suitable performance of these devices.

Among these stationary unsoldering units exist some of them that include a thermostat system to avoid the cooling of the unsolderer tip due to the continuous flow of the air under pressure, what increases the cost of these units.

The second group of unsolderers consists of manual unsolderers, among which are bulb unsolderers and piston unsolderers. The bulb unsolderers consist of, like all the unsolderers, a conduct on whose end is a resistance, being pumped the tin through the spring bulb which pumps after compressing its walls. The piston unsolderers, as indicated by their name, are manual devices that use a small piston, manually operated, to draft the welding material which goes to a small reservoir included in the same device.

This type of unsolderers, although are movable and much cheaper than the stationary unsolderers, have disadvantages that are much more important. First, there devices are much slower because the compression of the bulb or piston causes the exhausting of the welding material contained in the same bulb or reservoir, depending on the type, whereby this operation must be carried out in a direction different from the drafting direction, otherwise, there is the risk to be burned by the welding material expelled by the device. Therefore, these devices are very slow and uncomfortable for the user that must shift the unsolderer after each drafting. The steady flow of tin in both directions inside the conduct causes always the frequent jamming of this type of unsolderers.

It must be noted, as a factor causing the above-mentioned slow and uncomfortable use, that this needs to employ both hands for unsoldering.

All these drawbacks convert the manual unsolderers in devices with a poor effectiveness and suitability, being its application restricted to jobs that don't require a high accuracy.

The automatic portable unsolderer of this invention consists of a conventional heating member with a draft conduct for the unsoldering material, which has an outer threaded end for the engagement of different types of nozzles or tips used to melt the material. The conduct is suitably sized so that the melt material can flow through it when it is in a fluid condition and solidifies just after arriving to the reservoir.

The heating member is axially fitted through a flange and some screws to a refractory member, generally cylindrical-shaped, so that the conducts goes through a hole, remaining engaged by a teflon refractory bushing. In said member is mounted the reservoir, which is provided with a through cylindrical hole that is threaded to fit a plug, having a rear hole coaxially with the heating conduct, that communicates with a chamber whose diameter is higher than said hole.

The reservoir is provided with a retaining cylindrical member, loose fitted, with an incomplete axial groove to locate the portion of the heating conduct that remains introduced in said reservoir. The height of said retaining member is such that its lower base rests on the bottom of the container and its higher base frees a small portion of the above-mentioned rear hole.

The retaining hole has on the top two diametrically opposed holes for the fitting of the ends of a wire-shaped member like a clamp, so that said retaining member is easily removable to detach the tin adhered to its walls.

The main feature of this invention is two one-way valves reversely oriented on the refractory member. The valve that prevents the air going through the draft conduct, consists of an elastic lug disposed between the rear hole and the chamber to which is communicated. The second valve is another spring lug that covers outwards a radial hole made on the wall of said chamber. This second valve presents the drafted air going through the suction conduct.

On the rear side of the refractory member is made a screw thread to fit a neumatic cylinder whose piston is provided with a rod that constitutes the core of a solenoid supplied by an alternating current. During the air intake and exhaust motions, said rod slides in a locating cylindrical member fitted through a screw thread to the rear side of the cylinder jacket, and on which is axially disposed said solenoid to which remains fastened by some conventional fixing member (spring, circlip, and, so on), disposed at the rear end of the locating part.

In the rod of the piston is mounted a tapered spring that rests on a ring staggering of the locating member, and serves as returning member.

The cylinder jacket has on its rear side some holes that communicate the rear chamber with the outside to exhaust the air.

The unsolderer of the invention can include a diode mounted in series with the resistance of the heating member, so to be able to select a thermal value reduced to the half when the apparatus is not being used.

All the features listed in this specification define an automatic and portable unsoldering device which obviously constitutes an innovation in the related air, since it embraces the advantages of devices existing at present, being clearly superior with regard to suitability, effectiveness and handling.

To have a better understanding of this specification and as an integral member of the same, ther are annexed drawings in which its different Figures, given as an illustrative and un restrictive example, show as follows :

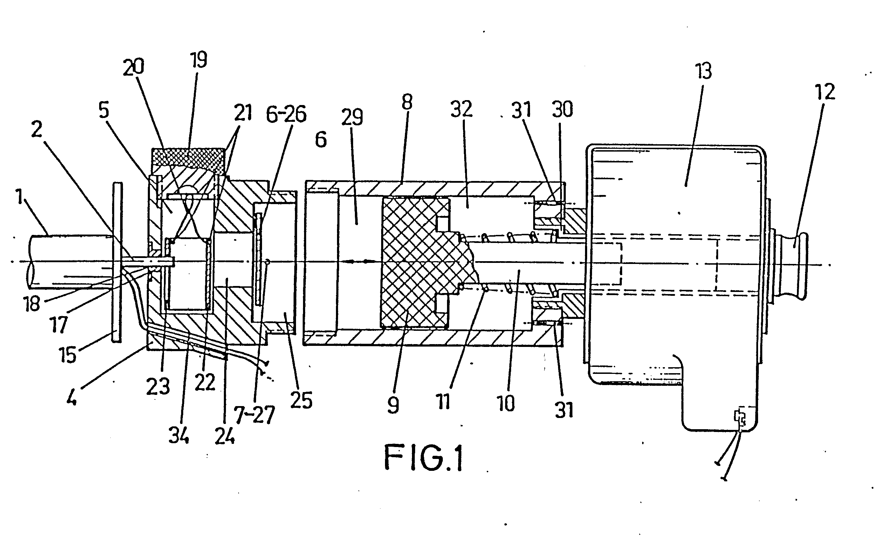

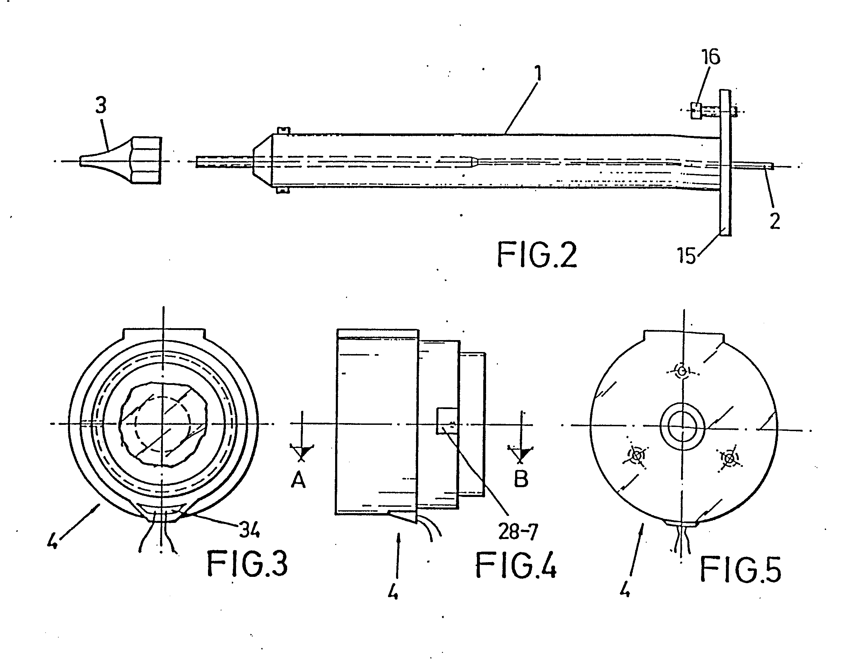

Fig. 1 and 2.-View of section of all the parts constituting the unsolderer of the invention.

Figure 3.-View of back elevation of the refractory member containing the reservoir and the two one-way valves.

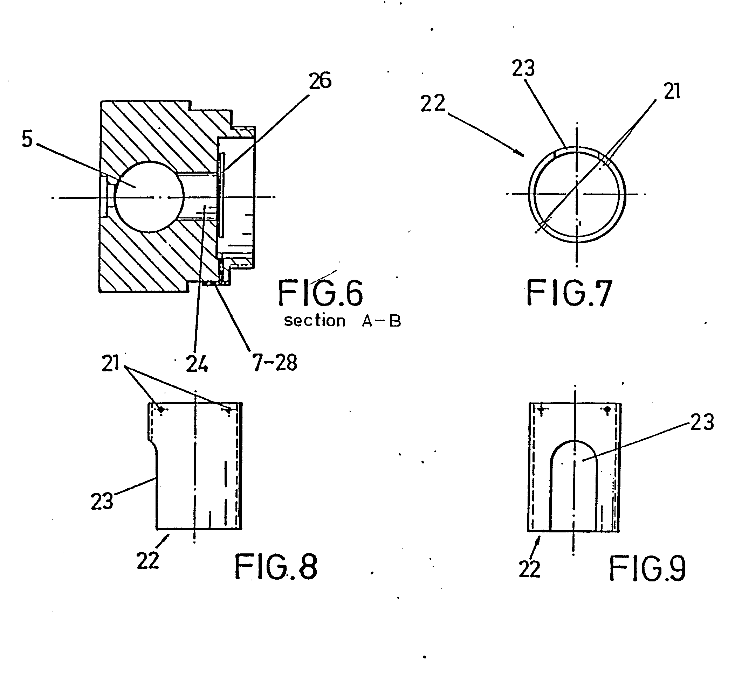

Figure 4.-Side view of the refractory member.

Figure 5.-View of back elevation of the refractory member shown in Fig. 3 and 4.

Figure 6.-View in section according to the front plant of the refractory member.

Figure 7.-View of plant of the retaining cylindrical member included in the reservoir.

Figure 8.-View of elevation of the retaining member.

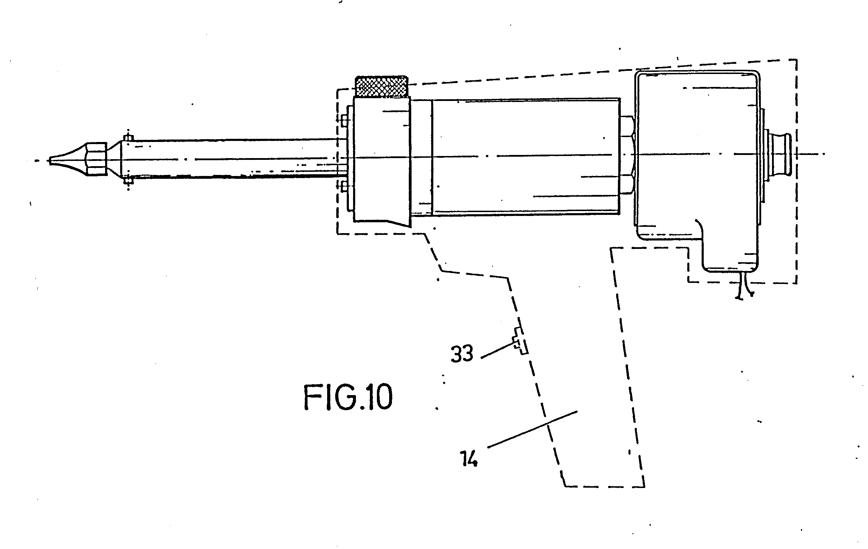

Figure 9.-Side view of the retaining member shown in the preceding Figures.

Figure 10.-Schematic view of the unsolderer of the invention provided with housing.

Refering to the numbers relative to the above-mentioned Figures, one can note that the unsolderer of the invention essentially consists of a heating member (1) provided with its relative suction conduct (2) and a nozzle or tip (3), a refractory member (4) including the reservoir (5) and the one-way valves (6) and (7), a neumatic cylinder (8) with its relative piston (9) and rod (10), a return tapered spring (11), a locating cylindrical member (12), a solenoid supplied by alternating current (13) and an ergonomic housing (14).

The heating member (1) includes a suction conduct (2) specially sized so that the unsoldering material arrives to the reservoir (5) at the suitable temperature. The end of said conduct (2) has a screw thread for use of removable nozzles (3).

The heating member (1) is fitted to a refractory member (4) through a flange (15) with screws (16), while a portion of the suction conduct (2) remains introduced, with a refractory bushing (17), in an axial hole (18) disposed in said refractory member (4), and communicated with the reservoir (5) for collection and removal of the soldering material.

The reservoir (5), shaped as a transverse cylindrical hole made in the refractory member (4), is threaded so to accommodate a locking plug (19). Inside the reservoir is loose fitted a retaining cylindrical member (22) showing in its top surface two diametrically opposed holes for fixing the wire member (20), which serves as gripper to remove said retaining member.

The refractory member (4), generally cylindrical-shaped, has a hole (24) coaxial with the hole (18) housing the refractory bushing (17) and is disposed in the generating surface of the reservoir (5) diametrically opposed to the latter. This hole (24) coaxially communicates with a cylindrical chamber (25) having a higher diameter, being the hole (24) and said chamber (25) separated by a spring lug (26) that defines the one-way valve (6).

In the wall of the chamber (25) a hole has been made with an outer spring lug (28) operating as one-way valve (7) reversely oriented with regard to the former (6).

Through an outer thread provided in the refractory member (14) this is fitted to a neumatic cylinder (8) whose intake chamber (29) communicates with the cylindrical chamber (25). The rod (10) of the piston (9) of said cylinder, constitutes the core of a solenoid (13) supplied by an alternating current and it has a return tapered spring (11). The cylinder (8) is fitted through a screw thread to a locating cylindrical member (12) coaxial with the solenoid (13) and integral with the same through suitable means (spring, pin, circlip, and so on), so that the rod (10) constitutes the core of said solenoid and can move by exciting this, and to withdraw driven by the return spring (11) whose rear ends abuts against a ring-shaped step (3) disposed in the locating cylindrical member (12).

The withdrawing movement of the rod is easily carried out through some exhaust ports (31) placed in the jacket of the cylinder rear chamber (32).

The above-mentioned automatic portable unsolderer is shown engaging an ergonomic housing (14) enveloping suitably all the parts and in which is disposed the switch actuator (33).

The leads of the resistance of the heating member (1) go through the hole (34) provided in the refractory member (4).

The operation of the unsolderer proposed by the invention is as follows:

After connecting an electric power source to the heating member (1) and the alternating current solenoid (13), the unsoldering operation can be carried out.

The unsoldering nozzle or tip (3) contacts the material to be unsoldered and when this is melt, the switch (33) provided in the housing is operated, exciting the solenoid (13) that attracts the rod (10) and, therefore, the plunger (9), causing the suction of the air through the valve (6) and the suction of the unsoldering material which goes after melting through the suction conduct (2) and arrives to the reservoir (5) in a solid condition. The retaining member (20) prevents that the drafted materials goes through the hole (24) to the cylinder (8), avoiding so the damage of the jacket, piston (9) and the remaining parts.

When we stop depressing the switch (33) the piston (9) goes back to its starting position due to the tapered spring (11) that abuts against the ring-shaped step (30) of the locating member (12). The air driven by the piston (9) is by-passed through the valve (7).

In this way, as many operations as desired can be carried out without moving the device. When we want to empty the reservoir, we only need to unscrew the plug (19), to remove the retaining member (23) through the wire member (20) and to upset the unsolderer.

The device of the invention can be used as an unsolderer, by connecting the heating member to the power source.

Shortly, the features and advantages of the proposed unsolderer are as follows:
-Portable apparatus.
-Automatic operation.
-Simple removal.
-Reduced maintenance.
-Easy and comfortable handling.
-As many as suctions as desired can be carried out without moving the device.
-No jamming.
-Very fast.
-It can be used as unsolderer, like the conventional unsolderers.
-Ver efficient.
-Low producing cost.

Shortly, the requested Invention Patent will be based on the following :

## Claims

1.-Automatic portable unsolderer, including a heating member to melt the soldering material, a reservoir for collection and removal of said material and suction means, is charcterized for including a cylinder, preferably of aluminum, provided with a piston whose rod constitutes the core of a solenoid supplied by an alternating current, resulting from its operation the withdrawing movement of the piston to suction the soldering material, after its melting through the relative nozzle fitted in the end of the heating member, through whose conduct flows the melted soldering material to said collection and removal reservoir, arriving the former in a solid condition ; having the peculiarity that the suction of the soldering material to be retained in said reservoir, is carried out by drafting atmospheric air that goes through a one-way valve axially disposed that prevents the air going out through the heating conduct, being exhausted through a second one-way valve reversely oriented and radially mounted.

2.-Automatic portable unsolderer, according to the claim 1, characterized for the retaining member, including the reservoir, has two diametrically disposed holes on its top surface, to engage the ends of a clamp-shaped wire member used for removal.

3.-Automatic portable unsolderer, according to the claim 1, characterized for having on the suction conduct end a screw thread to engage different types of nozzles.

4.-Automatic portable unsolderer, according to the claim 1, characterized for the piston rod is housed in a locating cylindrical member, coaxially with the solenoid and fixed to this by an end, with suitable means, showing on the opposite end a screw thread to engage the cylinder.

5.-Automatic portable unsolderer, according to the claim 1, characterized for said cylinder has at least two holes which communicate the rear chamber and the outside, to eject the air housed in the former.

6.-Automatic portable unsolderer, according to the claim 1, wherein the piston rod has axially disposed a return tapered spring.

7.-Automatic portable unsolderer, according to the claim 1, wherein the heating member, the reservoir member, the cylinder and the electric coil for alternating current, are axially engaged and disposed inside an ergonomic housing provided with means to operate the device.

8.-Automatic portable unsolderer object of the requested Invention Patent.
This device corresponds to the above-mentioned Specification consisting of the eleven typed sheets and annexed drawings.

FIG.1

FIG.2

FIG.3

FIG.4

FIG.5

FIG.6
section A-B

FIG.7

FIG.8

FIG.9

0 266 844

FIG.10

33

14

0 266 844